(19) **Europäisches Patentamt / European Patent Office / Office européen des brevets**

(11) **EP 1 080 492 B1**

(12) **EUROPÄISCHE PATENTSCHRIFT**

(45) Veröffentlichungstag und Bekanntmachung des Hinweises auf die Patenterteilung:
**19.08.2009 Patentblatt 2009/34**

(21) Anmeldenummer: **00916805.5**

(22) Anmeldetag: **13.03.2000**

(51) Int Cl.:
***H01L 21/66*** (2006.01)      ***B81C 5/00*** (2006.01)

(86) Internationale Anmeldenummer:
**PCT/DE2000/000749**

(87) Internationale Veröffentlichungsnummer:
**WO 2000/055899 (21.09.2000 Gazette 2000/38)**

(54) **VORRICHTUNG UND VERFAHREN ZUR BESTIMMUNG DER LATERALEN UNTERÄTZUNG EINER STRUKTURIERTEN OBERFLÄCHENSCHICHT**

DEVICE AND METHOD FOR DETERMINING THE LATERAL UNDERCUT OF A STRUCTURED SURFACE LAYER

DISPOSITIF ET PROCEDE DE DETERMINATION DE LA GRAVURE SOUS-JACENTE LATERALE D'UNE COUCHE SUPERFICIELLE STRUCTUREE

(84) Benannte Vertragsstaaten:
**DE FR GB NL**

(30) Priorität: **12.03.1999 DE 19910983**

(43) Veröffentlichungstag der Anmeldung:
**07.03.2001 Patentblatt 2001/10**

(73) Patentinhaber: **ROBERT BOSCH GMBH 70442 Stuttgart (DE)**

(72) Erfinder:
  • **BECKER, Volker**
    **D-76359 Marxzell (DE)**
  • **LAERMER, Franz**
    **D-70437 Stuttgart (DE)**
  • **SCHILP, Andrea**
    **D-73525 Schwaebisch Gmuend (DE)**

(56) Entgegenhaltungen:
  WO-A-96/42110          WO-A-97/45873
  US-A- 4 039 370

  • ZINCKE C ET AL: "TEST STRUCTURES FOR DETERMINING DESIGN RULES FOR MICROELECTROMECHANICAL-BASED SENSORS AND ACTUATORS" PROCEEDINGS OF THE INTERNATIONAL CONFERENCE ON MICROELECTRONIC TEST STRUCTURES (ICMTS), US, NEW YORK, IEEE, 1994, Seiten 44-50, XP000481292 ISBN: 0-7803-1757-2

**Beschreibung**

Stand der Technik

Die Erfindung betrifft eine Vorrichtung und ein Verfahren zur Bestimmung einer zumindest bereichsweisen lateralen Unterätzung einer strukturierten Oberflächenschicht nach der Gattung der unabhängigen Ansprüche.

Es ist bekannt, oberflächenmikromechanische Strukturen in einer Siliziumschicht in Flußsäuredampf zu ätzen und zur Erzielung einer Unterätzung einer strukturierten Oberflächenschicht aus Silizium eine Opferschicht aus Siliziumdioxid unter der zu strukturierenden Oberflächenschicht anzubringen. Der Flußsäuredampf bewirkt dabei bei einer Ätzung der Opferschicht eine rein zeitkontrollierte Unterätzung der strukturierten Oberflächenschicht, so daß die jeweils in der Opferschicht erreichte Unterätzweite, beispielsweise zur definierten Freilegung freistehender Sensorstrukturen in der Oberflächenschicht, im Laufe der Flußsäuredampfunterätzung nicht direkt meßbar bzw. während der Ätzung nicht kontrollierbar ist. Daher besteht permanent die Gefahr, ungewollt zu kurz oder zu lang zu ätzen. Insbesondere ein zu langes Ätzen kann zur Zerstörung von Strukturen auf einem Wafers führen, indem diese sich beispielsweise vom Substrat ablösen.

Aufgabe der vorliegenden Erfindung war daher ein Verfahren und eine zu dessen Durchführung geeignete Vorrichtung bereitzustellen, das es erlaubt, die erreichte Unterätzweite bzw. Ausdehnung der Unterätzung einer strukturierten Oberflächenschicht permanent während der Unterätzung zu messen.

**Vorteile der Erfindung**

Das erfindungsgemäße Verfahren und die erfindungsgemäße Vorrichtung mit den kennzeichnenden Merkmalen der unabhängigen Ansprüche hat gegenüber dem Stand der Technik den Vorteil, daß es ermöglicht, die Ausdehnung der lateralen Unterätzung einer strukturierten Oberflächenschicht durch Ätzung einer Opferschicht permanent in situ d.h. während der Unterätzung als Funktion der Zeit zu bestimmen und diese damit kontrollieren und einstellen zu können.

Vorteilhafte Weiterbildungen der Erfindung ergeben sich aus den in den Unteransprüchen genannten Maßnahmen.

So ist es sehr vorteilhaft, wenn die physikalische Meßgröße eine Kapazität, eine absorbierte oder emittierte Intensität einer elektromagnetischen Strahlung, eine absorbierte oder emittierte Frequenz, insbesondere Resonanzfrequenz, oder ein absorbiertes oder emittiertes Frequenzspektrum einer elektromagnetischen Strahlung ist. Dabei wird erfindungsgemäß über mindestens einen Sender ein erstes Signal emittiert, mit dem das passive elektronische Bauteil wechselwirkt, wobei ein zweites Signal erzeugt oder das erste Signal zu einem zweiten Signal modifiziert wird, welches wiederum über mindestens einen Empfänger detektiert wird. Die physikalische Meßgröße und somit die dazu proportionale Unterätzung wird dann aus dem zweiten Signal oder aus dem Unterschied zwischen dem ersten und dem zweiten Signal bestimmt.

Sender und Empfänger befinden sich dabei sehr vorteilhaft außerhalb der eigentlichen Ätzkammer und bleiben so vor einem Ätzangriff, insbesondere durch aggressive Ätzgase wie HF-Dampf, $C1F_3$, $XeF_2$ und ähnliche geschützt. Somit kann gleichzeitig sehr vorteilhaft auf eine aufwendige Verschaltung und Kontaktierung des passiven elektronischen Bauelementes verzichtet werden. Die Wechselwirkung von passivem Bauelement und Sender bzw. Empfänger erfolgt somit vorteilhaft berührungslos.

Besonders vorteilhaft ist weiterhin, wenn der Sender und Empfänger in einem Bauteil, insbesondere einer Verarbeitungseinheit integriert sind und/oder der Sender gleichzeitig auch Empfänger ist. Insbesondere im letzteren Fall können sehr vorteilhaft charakteristische elektrische Parameter des Senders, die auf Veränderungen eines elektromagnetischen Strahlungsfeldes reagieren, wie beispielsweise interne Spannungen, Ströme oder Phasen zwischen internen Spannungen und Strömen, in einfacher Weise detektiert oder ausgewertet werden.

Als erstes Signal eignet sich besonders vorteilhaft eine an das passive elektronische Bauteil eingekoppelte oder anliegende elektrische Spannung, eine eingestrahlte oder eingeleitete Intensität einer elektromagnetischen Strahlung, oder, besonders vorteilhaft, ein in das passive elektronische Bauteil eingestrahlte oder eingeleitete, kontinuierlich oder impulsartig emittierte Hochfrequenzleistung mit vorgegebener Frequenz oder vorgegebenem Frequenzspektrum oder eine Abfolge gechirpter Hochfrequenzimpulse elektromagnetischer Strahlung.

Ebenso ist auch das zweite Signal vorteilhaft eine elektrische Spannung, eine absorbierte oder emittierte Intensität elektromagnetischer Strahlung oder eine absorbierte oder emittierte Frequenz, insbesondere eine Resonanzfrequenz, oder ein Frequenzspektrum elektromagnetischer Strahlung.

Weiterhin ist es besonders vorteilhaft, wenn das passive elektronische Bauteil eine aus der strukturierten und zumindest bereichsweise zu unterätzenden Oberflächenschicht zusätzlich herausstrukturierte Spule ist, die mit einer darunter befindlichen Grundschicht gleichzeitig einen Kondensator bildet, bei dem die Opferschicht als Dielektrikum dient. Die Kapazität C dieses Kondensators ist dann proportional zu der zu bestimmenden Ausdehnung der lateralen Unterätzung der strukturierten Oberflächenschicht. Die Spule und der mit ihr und der darunter befindlichen Grundschicht gebildete Kondensator stellen somit einen LC-Schwingkreis mit einer Resonanzfrequenz $f_0$ dar, deren Änderung $\Delta f_0$ dann proportional zu der zu bestimmenden Ausdehnung der bereichsweisen lateralen Unterätzung der Oberflächenschicht ist. Dabei ist vorteilhaft mindestens eines der beiden Spulenenden der als passives elektronisches Bauteil zusätzlich herausstrukturierten Spule in seiner Ausdehnung derart dimensioniert, daß eine vollständige Unterätzung des Spulenendes unterbleibt. Somit bleibt die Spule stets auch zumindest einseitig auf der Grundschicht befestigt und fällt beispielsweise nicht herunter.

Als Materialien für die Grundschicht eignet sich insbesondere Silizium oder ein Siliziumwafer. Die Oberflächenschicht besteht vorteilhaft ebenfalls aus Silizium oder Polysilizium, das beispielsweise zur Verbesserung der elektrischen Eigenschaften dotiert und/oder oberflächlich metallisiert sein kann. Als Opferschicht eignet sich vorteilhaft ein zumindest im Bereich des passiven elektronischen Bauteils bzw. der Spule elektrisch isolierendes Material wie Siliziumdioxid.

Das erfindungsgemäße Verfahren eignet sich besonders zur definierten Unterätzung, insbesondere in einer Dampfphase von HF-Dampf oder in einer Gasphase, beispielsweise mit $C1F_3$, $BrF_3$ oder $XeF_2$, und damit zur Erzeugung freistehender Sensorstrukturen in der strukturierten Oberflächenschicht. Es eignet sich in der Regel nicht zum Einsatz in flüssigen Ätzmedien wie beispielsweise wäßriger Flußsäure, da beispielsweise die Einstrahlung von Hochfrequenzstrahlung in einen Elektrolyten aufgrund einer starken Strahlungsdämpfung schwierig ist.

## Zeichnung

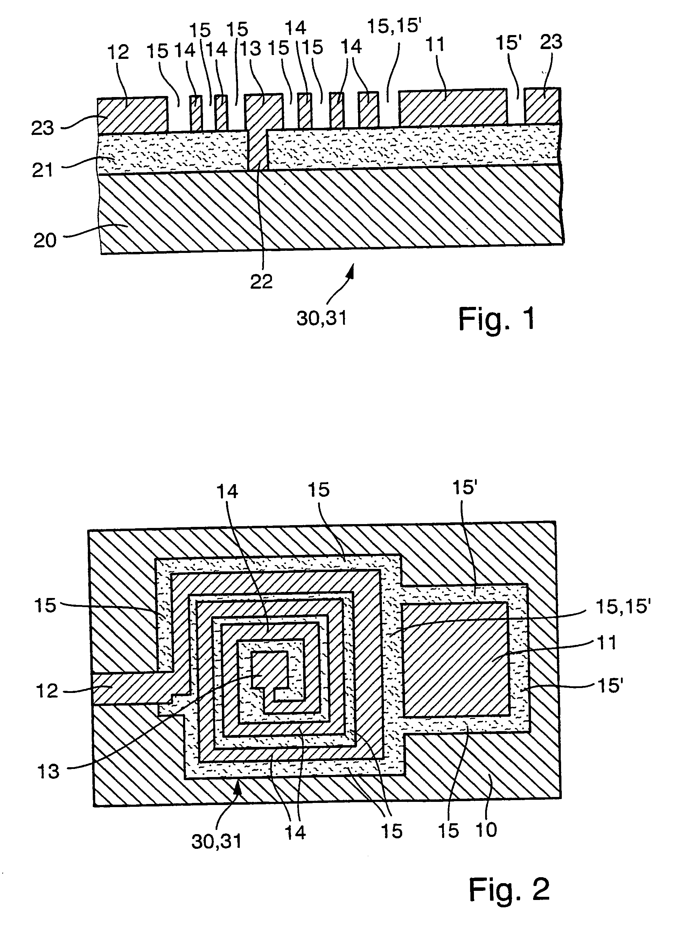

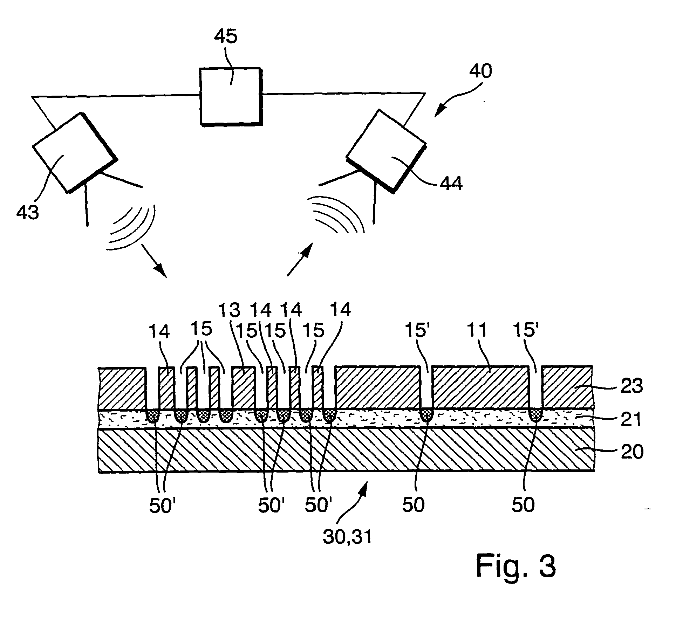

Ausführungsbeispiele der Erfindung werden anhand der Zeichnungen und in der nachfolgenden Beschreibung näher erläutert. Die Figur 1 zeigt einen Schnitt durch eine Schichtanordnung mit einer strukturierten Oberflächenschicht, Figur 2 eine Draufsicht auf Figur 1 und Figur 3 eine weitere Ausführungsform der Schichtanordnung nach Figur 1 mit zusätzlichen externen Baugruppen.

## Ausführungsbeispiele

Figur 1 zeigt eine Schichtanordnung mit einer strukturierten Oberflächenschicht 23, einer Opferschicht 21 und einer Grundschicht 20. Die Oberflächenschicht 23 besteht aus Silizium oder Polysilizium, das oberflächlich metallisiert ist, die Opferschicht 21 aus Siliziumdioxid und die Grundschicht 20 wird durch einen Siliziumwafer gebildet. Ein derartiger Aufbau ist beispielsweise bereits in der Anmeldung DE 198 47455.5 beschrieben worden. Aus der Oberflächenschicht 23 ist weiterhin bereichsweise mindestens ein passives elektronisches Bauteil 31 in Form einer Spule 30 herausstrukturiert, wobei die Spule 30 ein erstes Spulenende 13 und ein zweites Spulenende 12 sowie Spulenwindungen 14 aufweist, die über in der Oberflächenschicht 23 herausstrukturierte, in der Tiefe bis zur Opferschicht 21 reichende Trenchgräben 15 voneinander separiert sind. Das erste Spulenende 13 ist über eine Durchkontaktierung 22 mit der Grundschicht 20 verbunden, die elektrisch leitfähig ist. Die Spule 30 mit ihrer Induktivität L bildet somit mit der Grundschicht 20 einen Kondensator mit einer Kapazität C und der Opferschicht 21 als Dielektrikum.

Weiterhin ist aus der strukturierten Oberflächenschicht 23 mindestens eine zu unterätzende oder freizulegende Struktur 11 über Trenchgräben 15' herausstrukturiert, wobei auch die Trenchgräben 15' in der Tiefe bis zur Opferschicht 21 reichen. In der Praxis sind aus der Oberflächenschicht 23 eine Vielzahl von gegebenenfalls unterschiedlichen Strukturen 11 herausstrukturiert, während in der Regel maximal einige passive elektronische Bauteile 31 zur Bestimmung der Ausdehnung der lateralen Unterätzung ausreichend sind. Die Form der Struktur 11 unterliegt dabei keinerlei Beschränkung. Es kann sich dabei um eine freizulegende Struktur 11 in Form eines Mikroschwingspiegels, eines Sensors oder lediglich eines Bereiches der Oberflächenschicht 23 handeln. Insbesondere muß die Struktur 11 dabei nicht von den Trenchgräben 15' umgeben sein, sondern es genügt, wenn lediglich über einen Trenchgraben 15', der beispielsweise auch als Loch ausgebildet sein kann, eine laterale Unterätzung der Struktur 11 ermöglicht wird.

Figur 2 zeigt eine Draufsicht auf Figur 1, wobei sich die Spule 30 in diesem Fall beispielhaft in unmittelbarer Nähe zu der Struktur 11 befindet und die Struktur 11 eine vollständig oder teilweise zu unterätzende Platte 11 ist, bei der die Ausdehnung der Unterätzung mit Hilfe des passiven elektronischen Bauteils 31 bzw. der Spule 30 zu bestimmen ist. Außerdem sind das erste und das zweite Spulenende 12, 13 jeweils gegenüber den Spulenwindungen 14 großflächig gestaltet, um eine vollständige Unterätzung zumindest eines der Spulenenden 12 oder 13 zu vermeiden. Die Dimensionierung der Spulenenden 12, 13, die Anzahl der Spulenwindungen 14, die Breite der Trenchgräben 15 und 15' und die Form der Spule 30, die in Figur 2 lediglich beispielhaft in Form eines rechtwinkligen Mäanders ausgeführt ist, ergibt sich im Einzelfall anhand der zu bestimmenden lateralen Ausdehnung der Unterätzung. Hinsichtlich dieser Größen sind die Figuren 1 bis 3 nicht maßstäblich zu verstehen. Insbesondere können die Windungen der Spule 30 auch spiralförmig ausgebildet sein, die von den Spulenenden 12, 13 eingenommenen Flächen können deutlich größer als die Fläche der Struktur 11 sein und die Breite der Trenchgräben 15 kann vergleichbar mit der Breite der Struktur 11 sein. Die geeignete Dimensionierung der einzelnen Baugruppen kann der Fachmann im konkreten Fall anhand einfacher Überlegungen und Vorversuche vornehmen. Dabei hängt die Dimensionierung beispielsweise auch von dem Frequenzbereich ab, in dem man arbeiten möchte.

Die Figur 3 zeigt eine Weiterbildung der Figur 1 mit weiteren externen Baugruppen. Dabei wird von einem externen Sender 43 ein erstes Signal emittiert, das mit dem passiven elektronischen Bauteil 31 bzw. der Spule 30 wechselwirkt und dadurch das erste Signal zu einem zweiten Signal modifiziert oder ein zweites Signal emittiert. Der Empfänger 44 empfängt dann dieses zweite Signal. Dabei können Sender 43 und Empfänger 44 sowohl kontinuierlich (gleichzeitiges Senden und Empfangen) als auch abwechselnd (abwechselndes Senden und Empfangen) arbeiten. Weiterhin ist ein Korrelator 45 vorgesehen, der die physikalische Meßgröße in an sich bekannter Weise aus dem zweiten Signal oder aus dem Unterschied zwischen dem ersten und dem zweiten Signal bestimmt. In Figur 3 bilden demnach Sender 43, Empfänger 44 und Korrelator 45 eine Verarbeitungseinheit 40, die außerhalb des Siliziumwafers sitzt und berührungslos mit der Spule 30 bzw. dem von der Spule 30 und der Grundschicht 20 gebildeten Schwingkreis über elektromagnetische Strahlung wechselwirkt. Die Verarbeitungseinheit 40 kann somit auch außerhalb der eigentlichen Ätzanlage angeordnet sein und ist dort insbesondere nicht dem Angriff eines aggressiven Ätzmediums ausgesetzt. Auch eine Verschaltung mit der Spule 30 ist somit nicht erforderlich.

In Figur 3 ist weiter angedeutet, wie eine Unterätzung der strukturierten Oberflächenschicht 23 durch Ätzung der Opferschicht 21, beispielsweise in an sich bekannter Weise in Flußsäuredampf, von den Ätzbereichen 50 und 50' am Boden der Trenchgräben 15, 15' ausgeht.

Im einzelnen wird im erläuterten Ausführungsbeispiel gemäß Figur 1 auf einem Siliziumwafer als Grundschicht 20 zunächst eine Siliziumdioxidschicht als Opferschicht 21 aufgebracht. Auf dieser Opferschicht 21 wird dann eine Oberflächenschicht 23 aus Silizium oder Polysilizium aufgebracht, die oberflächlich metallisiert ist. Anschließend wird die Oberflächenschicht 23 in an sich bekannter Weise über eine Maskierung strukturiert und Trenchgräben 15 und 15' in die Oberflächenschicht 23 geätzt, die in der Tiefe bis zu der Opferschicht 21 reichen. Die Trenchgräben 15' umgeben dabei mindestens eine zu unterätzende und insbesondere freizulegende Struktur 11. Gleichzeitig werden mit dem Ätzprozeß zur Strukturierung der Oberflächenschicht 23 auch eine oder mehrere passive elektronische Bauteile 31 in Form einer Spule 30 in die Oberflächenschicht 23 eingeätzt bzw. aus dieser herausstrukturiert, so daß mehrere Spulenwindungen 14 in dem Silizium der Oberflächenschicht 23 ausgeführt sind, die auf dem gleichen Opferoxidtyp bzw. der gleichen Opferschicht 23 angeordnet sind, wie die freizulegenden Strukturen 11.

Das erste Spulenende 13 oder das zweite Spulenende 12 der Spule 30 kann zusätzlich mit einer Durchkontaktierung 22 in Form eines Kontaktloches mit der Grundschicht 20 elektrisch verbunden sein (siehe Figur 1). Alternativ kann auch mindestens eines der beiden Spulenenden 12, 13 so weit verbreitert werden, daß es während der Unterätzung der freizulegenden Struktur 11 sicher nicht vollständig unterätzt wird, so daß die Spule 30 wenigstens einseitig auf der Opferschicht 21 befestigt bleibt (siehe Figur 3). Weiterhin ist es auch möglich, beide Spulenenden 12, 13 so zu verbreitern, daß beide bei der Unterätzung nicht vollständig unterätzt werden. Falls eines der Spulenenden 12, 13 nicht verbreitert ist und beim Unterätzen der freizulegenden Struktur 11 vollständig unterätzt wird, ist es auch möglich, eine nach Abschluß der Unterätzung freitragende Konstruktion der Spule 30 zu erhalten, sofern das jeweils andere Spulenende verbreitert oder, besonders bevorzugt, mit einer Durchkontaktierung 22 mit der Grundschicht 20 verbunden ist. Als besonders günstig hat sich eine Kombination eines verbreiterten Spulenendes mit einem mit der Grundschicht 20 über eine Durchkontaktierung 22 verbundenen Spulenende herausgestellt.

Die Anordnung der Spulenwindungen 14 mit dem darunterliegenden Siliziumdioxid der Opferschicht 21 bildet zur Grundschicht 20 hin einen Kondensator mit über die Länge der Spulenwindungen 14 verteilten Kapazität C. Die Spule 30 hat als elektrischer Leiter gleichzeitig eine Induktivität L, so daß in jedem Fall ein Schwingkreis entsteht, dessen Resonanzfrequenz $f_0$ durch die Induktivität L und die Kapazität C über

$$f_0 = \frac{1}{\sqrt{LC}} * \frac{1}{2\pi}$$

gegeben ist. In bevorzugter Ausführung ist die Oberfläche der Oberflächenschicht 23 im Bereich der Spule 30 beispielsweise durch Aluminium, AlSiCu oder AlSi metallisiert, wobei diese Metallisierung gleichzeitig auch als Kontaktmaterial für die Struktur 11 dienen kann. Durch die Metallisierung wird der ohmsche Widerstand der Spulenwindungen 14 erheblich vermindert und somit eine möglichst hohe Resonanzgüte des gebildeten LC-Schwingkreises erzielt. Damit ist eine scharfe Definition der Resonanzfrequenz des, gebildeten Schwingkreises durch eine hohe Resonanzgüte aufgrund geringer elektrischer Dämpfung gewährleistet.

Aufgrund der Dielektriziätszahl von Siliziumdioxid $\varepsilon_{oxid}$ von 3,88 im Vergleich zu der von Luft $\varepsilon_{Luft}$ von 1, nimmt die Kapazität C des Kondensators in dem Maße ab, wie die Opferschicht 21 unter der Spule 30 bzw. den Spulenenden 14 und/oder 13 durch laterales Unterätzen in Flußsäuredampf weggeätzt wird und dabei durch Luft oder Flußsäuredampf ersetzt wird. Die Opferschicht 21 als Dielektrikum ändert somit während der Unterätzung ständig ihre effektive Dielektrizitätszahl, wobei die sich als Funktion der Unterätzung einstellende effektive Dielektrizitätszahl proportional zu der lateralen Ausdehnung der Unterätzung der Spule 30 ist. Für die Änderung der Kapazität C des von der Spule 30 und der Grundschicht 20 gebildeten Kondensators gilt:

$$C = \varepsilon\varepsilon_0 \frac{A}{d} \qquad \text{und} \qquad \Delta C = \varepsilon_0 \frac{\Delta A}{d}(\varepsilon_{Oxid} - 1)$$

Dabei bezeichnet $\Delta A$ die Fläche der durch die Unterätzung entfernten Opferschicht 21 unter der Spule 30 und d den Abstand von Spule 30 und Grundschicht 20, d.h. die Dicke der ursprünglich vorhandenen Opferschicht 21.

Die gemessene laterale Ausdehnung der Unterätzung der Spule 30 ist somit ein Maß für die laterale Ausdehnung der Unterätzung der Struktur 11.

Die Änderung der Kapazität $\Delta C$ des Schwingkreises ist wiederum sehr genau über die Veränderung $\Delta f_0$ der Resonanzfrequenz $f_0$ des LC-Schwingkreises meßbar, wobei in 1. Näherung gilt:

$$\Delta f_0 = -\frac{1}{2}\frac{\Delta C}{C} f_0$$

Die meßtechnische Erfassung der Resonanzfrequenz $f_0$ des Schwingkreises oder deren Änderung $\Delta f_0$ mit fortschreitender Unterätzung kann dabei auf vielfältige, an sich bekannte Arten erfolgen. Besonders geeignet ist die resonante Absorption und Wiederabstrahlung von eingestrahlter oder eingeleiteter Hochfrequenzleistung. Dazu strahlt man beispielsweise gemäß Figur 3 mit einem sogenannten "Grid-Dipper" als Verarbeitungseinheit 40 eine Hochfrequenz beim Unterätzen im Flußsäuredampf in die dazu verwendete Ätzvorrichtung ein, deren Frequenzlage manuell oder automatisch variiert wird. Bei automatischer Variation spricht man auch von einem "Frequenz-Sweep" oder "Wobbeln". Im Resonanzfall, d.h. wenn die von außen angelegte oder eingestrahlte Frequenz mit der Resonanzfrequenz des Schwingkreises zusammenfällt, bewirkt der Schwingkreis dann eine Veränderung mindestens einer charakteristischen elektrischen oder physikalischen Meßgröße, die detektiert wird. So hat eine Resonanzabsorption durch das passive elektronische Bauteil 31 bzw. den von Spule 30 und Grundschicht 20 gebildeten LC-Schwingkreis aus einem externen hochfrequenten Strahlungsfeld emitterseitig, d.h. im Sender 43, eine Änderung von Spannungen, Strömen oder Phasen zwischen Strömen und Spannungen zur Folge, die als Meßgrößen im Sender 43 selbst detektierbar sind. Dazu eignet sich beispielsweise der Gitterstrom einer die eingestrahlte oder eingeleitete Hochfrequenz erzeugenden, als Hochfrequenzgenerator dienenden Oszillatorröhre (Elektronenröhre), aus der sich auch der Name "Grid-Dipper" für dieses Meßgerät herleitet, da der Gitterstrom (grid) einer solchen Oszillatorröhre im Fall der Resonanz mit einem externen Schwingkreis gut meßbar einbricht (dip).

Entsprechende elektrische Größen treten jedoch auch bei Transistoroszillatoren auf, wenn ein externer Schwingkreis von der eingestrahlten Hochfrequenz resonant getroffen wird und dabei Energie aus dem Strahlungsfeld aufnimmt. Wesentlich in den erläuterten Ausführungsbeispielen ist stets die Veränderung im Strahlungsfeld durch eine Resonanzabsorption, die dann auf vielfältige, jeweils an sich bekannte Weise detektiert und beispielsweise hinsichtlich ihrer Frequenz genau bestimmt werden kann.

Ein weiteres Ausführungsbeispiel, insbesondere zur Bestimmung der Resonanzfrequenz des Schwingkreises, sieht vor, in den mit der Spule 30 gebildeten Schwingkreis sogenannte "gechirpte" Hochfrequenzimpulse über den Sender 43 der Verarbeitungseinheit 40 gemäß Figur 3 einzustrahlen, d.h. Hochfrequenzimpulse, deren Frequenz sich mit einer vorgegebenen Zeitfunktion (beispielsweise linear) rasch ändert. Dabei muß der gechirpte Hochfrequenzimpuls mit seinem überstrichenen Hochfrequenzbereich auch die Resonanzfrequenz des gebildeten Schwingkreises überstreichen, damit dieser während der Dauer des eingestrahlten Impulses irgendwann resonant erregt wird. Nach jedem gechirpten Hochfrequenzimpuls wird dann in einer Sendepause mit dem Empfänger 44 die Abstrahlung elektromagnetischer Strahlung durch den Schwingkreis gemessen ("Echo") und der Wert der abgestrahlten Resonanzfrequenz, d.h. der Resonanzfrequenz des Schwingkreises, die wiederum proportional zur zu bestimmenden lateralen Unterätzung ist, mit einem Standardfrequenzmeßverfahren ermittelt.

In einem weiteren Ausführungsbeispiel wird, in Abänderung des zuvor erläuterten Ausführungsbeispiels, anstelle einer Abfolge gechirpter Hochfrequenzimpulse von dem Sender 43 eine Abfolge breitbandiger Rauschimpulse auf die Oberfläche der Oberflächenschicht 23 eingestrahlt d.h. Impulse aus einem statistischen Frequenzgemisch, das die Resonanzfrequenz des mit der herausstrukturierten Spule 30 gebildeten Schwingkreises auf dem Siliziumwafer einschließt. Am Ende jedes Rauschimpulses wird dann in einer Sendepause von dem Empfänger 44 wieder, wie zuvor erläutert, die vom LC-Schwingkreis abgestrahlte Hochfrequenzleistung (das "Echo") detektiert und in der Verarbeitungseinheit 40 hinsichtlich ihrer Frequenz ausgewertet. Der Schwingkreis nimmt somit während der Einstrahlung Energie auf, sobald er in seiner Resonanzfrequenz getroffen wird, die er anschließend auf dieser Frequenz wieder abstrahlt. In den Impulspausen ist die Wiederabstrahlung ("Echo") besonders leicht detektierbar, da kein starkes Sendersignal überlagert ist.

Die Resonanzfrequenz oder die Änderung der Resonanzfrequenz des Schwingkreises als physikalische Meßgröße ist auch in diesem Ausführungsbeispiel der zu bestimmenden Ausdehnung der lateralen Unterätzung proportional.

Es ist schließlich auch möglich, über den Sender 43 kontinuierlich ein breitbandiges Rauschspektrum einzustrahlen und dieses mit dem Sender 44 kontinuierlich zu detektieren. Da die Emission des LC-Schwingkreises in einem engen Band um dessen Resonanzfrequenz erfolgt, kann in diesem Fall das überlagerte Sendersignal von der Emission des LC-Schwingkreises zuverlässig und einfach getrennt und letztere identifiziert werden.

Offensichtlich eignen sich neben der Resonanzfrequenz des Schwingkreises auch eine vom Schwingkreis absorbierte oder emittierte Intensität einer elektromagnetischen Strahlung oder eine Phasenänderung im Strahlungsfeld als Funktion der Unterätzung als physikalische Meßgröße.

**Patentansprüche**

1. Vorrichtung zur Bestimmung der Ausdehnung einer zumindest bereichsweisen lateralen Unterätzung einer strukturierten Oberflächenschicht (23) auf einer Opferschicht (21), umfassend eine strukturierte Oberflächenschicht (23) auf einer Opferschicht (21), wobei die strukturierte Oberflächenschicht (23) bereichsweise mindestens ein passives elektronisches Bauteil (31) aufweist, mit dem eine physikalische Meßgröße bestimmbar ist, die zu der Ausdehnung der lateralen Unterätzung proportional ist,
**dadurch gekennzeichnet,**
**dass** mindestens ein Sender (43) vorgesehen ist, der ein erstes Signal emittiert und mindestens ein Empfänger (44) vorgesehen ist, der ein zweites Signal detektiert, wobei das passive elektronische Bauteil (31) mit dem ersten Signal wechselwirkt und dabei das zweite Signal erzeugt oder das erste Signal zu dem zweiten Signal modifiziert.

2. Vorrichtung nach Anspruch 1, **dadurch gekennzeichnet, dass** das passive elektronische Bauteil (31) geeignet ist zur Bestimmung einer Kapazität, einer absorbierten oder emittierten Intensität einer elektromagnetischen Strahlung, einer absorbierten oder emittierten Frequenz, insbesondere Resonanzfrequenz, oder eines absorbierten oder emittierten Frequenzspektrums einer elektromagnetischen Strahlung, die zu der Ausdehnung der lateralen Unterätzung proportional ist.

3. Vorrichtung nach Anspruch 1 oder 2, **dadurch gekennzeichnet, dass** das passive elektronische Bauteil (31) in Form einer Spule (30) ausgebildet ist.

4. Vorrichtung nach einem der Ansprüche 1 bis 3, **dadurch gekennzeichnet, daß** die physikalische Meßgröße aus dem zweiten Signal oder aus dem Unterschied zwischen dem ersten und dem zweiten Signal bestimmbar ist.

5. Vorrichtung nach einem der Ansprüche 1 bis 4, **dadurch gekennzeichnet, daß** Sender (43) und Empfänger (44) in einem Bauteil, insbesondere einer Verarbeitungseinheit (40) integriert sind und/oder daß der Sender (43) gleichzeitig auch Empfänger (44) ist.

6. Vorrichtung nach einem der Ansprüche 1 bis 5, **dadurch gekennzeichnet, daß** das erste Signal eine an dem passiven elektronischen Bauteil (31) anliegende Spannung, eine Intensität einer elektromagnetischen Strahlung, eine in das passive elektronische Bauteil (31) eingestrahlte, kontinuierlich oder impulsartig emittierte Hochfrequenzleistung mit vorgegebener Frequenz oder vorgegebenem Frequenzspektrum oder eine Abfolge gechirpter Hochfrequenzimpulse oder breitbandiger Rauschimpulse elektromagnetischer Strahlung ist, und daß das zweite Signal eine elektrische Spannung, eine absorbierte oder emittierte Intensität einer elektromagnetischen Strahlung oder eine Frequenz, insbesondere eine Resonanzfrequenz, oder ein Frequenzspektrum elektromagnetischer Strahlung ist.

7. Vorrichtung nach Anspruch 3, **dadurch gekennzeichnet, daß** das passive elektronische Bauteil (31) eine in der Oberflächenschicht (23) herausstrukturierte Spule (30) mit einem ersten Spulenende (13) und einem zweiten Spulenende (12) ist, wobei die Spule (30) mit einer Grundschicht (20) einen Kondensator mit der Opferschicht (23) als Dielektrikum bildet, dessen Kapazität C proportional zu der zu bestimmenden Ausdehnung der lateralen Unterätzung der Oberflächenschicht (23) ist.

8. Vorrichtung nach Anspruch 7, **dadurch gekennzeichnet, daß** die Spule (30) zusammen mit ihrer Kapazität C einen Schwingkreis mit einer Resonanzfrequenz $f_0$ bildet, deren Änderung $\Delta f_0$ proportional zu der zu bestimmenden Ausdehnung der lateralen Unterätzung der Oberflächenschicht (23) ist.

9. Vorrichtung nach Anspruch 7, **dadurch gekennzeichnet, daß** eine Durchkontaktierung (22) vorgesehen ist, die eines der Spulenenden (12, 13) mit der Grundschicht (20) verbindet.

10. Vorrichtung nach Anspruch 7, **dadurch gekennzeichnet, daß** mindestens eines der Spulenenden (12, 13) in seiner Ausdehnung derart dimensioniert ist, daß eine vollständige Unterätzung des Spulenendes (12, 13) unterbleibt.

11. Vorrichtung nach Anspruch 1, **dadurch gekennzeichnet, daß** die strukturierte Oberflächenschicht (23) zumindest im Bereich des passiven elektronischen Bauteiles (31) über die Opferschicht (21) von einer Grundschicht (20) separiert ist.

12. Vorrichtung nach Anspruch 11, **dadurch gekennzeichnet, daß** die Grundschicht (20) zumindest weitgehend aus Silizium oder Polysilizium besteht oder ein Siliziumwafer ist.

13. Vorrichtung nach Anspruch 1, **dadurch gekennzeichnet, daß** die Oberflächenschicht (23) zumindest in dem Bereich des passiven elektronischen Bauteils (31) elektrisch zumindest schwach leitend ist und insbesondere aus Silizium oder Polysilizium oder oberflächlich metallisiertem oder dotiertem Silizium oder Polysilizium besteht.

14. Vorrichtung nach Anspruch 1, **dadurch gekennzeichnet, daß** die Opferschicht (21) zumindest im Bereich des passiven elektronischen Bauteils (31) elektrisch isolierend ist und insbesondere aus einer Siliziumoxidschicht besteht.

15. Vorrichtung nach Anspruch 1, **dadurch gekennzeichnet, daß** die Oberflächenschicht (23) mit in der Tiefe bis zur Opferschicht (21) reichenden Trenchgräben (15, 15') versehen ist.

16. Vorrichtung nach Anspruch 15, **dadurch gekennzeichnet, daß** die Trenchgräben (15) eine zu unterätzende Struktur (11) in der Oberflächenschicht (23) begrenzen.

17. Verfahren zur Bestimmung der Ausdehnung der lateralen Unterätzung einer strukturierten Oberflächenschicht (23) auf einer Opferschicht (21), wobei in einem ersten Ätzverfahren die Oberflächenschicht (21) zumindest bereichsweise mit einer Strukturierung mit Trenchgräben (15') versehen wird und in einem zweiten Ätzverfahren, ausgehend von den Trenchgräben (15'), zumindest bereichsweise eine laterale Unterätzung der strukturierten Oberflächenschicht (23) vorgenommen wird, **dadurch gekennzeichnet, daß** in dem ersten Ätzverfahren aus der Oberflächenschicht (23) bereichsweise zusätzlich mindestens ein passives elektronisches Bauteil (31) herausstrukturiert wird, das beim Unterätzen der Oberflächenschicht (23) ebenfalls unterätzt wird und mit dem beim Unterätzen eine zur Ausdehnung der Unterätzung proportionale physikalische Meßgröße bestimmt wird.

18. Verfahren nach Anspruch 17, **dadurch gekennzeichnet, daß** die Strukturierung der Oberflächenschicht (23) über eine Maskierung erfolgt.

19. Verfahren nach Anspruch 17, **dadurch gekennzeichnet, daß** die Opferschicht (21) auf einer Grundschicht (20) aufgebracht wird.

20. Verfahren nach Anspruch 17, **dadurch gekennzeichnet, daß** das Herausstrukturieren des Bauteils (31) über das Ätzen von Trenchgräben (15) erfolgt.

21. Verfahren nach Anspruch 17, **dadurch gekennzeichnet, daß** eine Spule (30) als passives elektronisches Bauteil (31) aus der Oberflächenschicht (23) herausstrukturiert wird.

22. Verfahren nach Anspruch 21, **dadurch gekennzeichnet, daß** bei einem Unterätzen der Spule (30) die Resonanzfrequenz eines mit der Spule (30) gebildeten Schwingkreises gemessen und daraus die Ausdehnung der lateralen Unterätzung bestimmt wird.

**Claims**

1.  Device for determining the extent of an at least regional lateral undercut of a structured surface layer (23) on a sacrificial layer (21) comprising a structured surface layer (23) on a sacrificial layer (21), wherein the structured surface layer (23) has regionally at least one passive electronic component (31) which can be used to determine a physical measurement variable that is proportional to the extent of the lateral undercut,
    **characterized**
    **in that** at least one transmitter (43) is provided which emits a first signal, and at least one receiver (44) is provided which detects a second signal, wherein the passive electronic component (31) interacts with the first signal and in the process generates the second signal or modifies the first signal to form the second signal.

2.  Device according to Claim 1, **characterized in that** the passive electronic component (31) is suitable for determining a capacitance, an absorbed or emitted intensity of an electromagnetic radiation, an absorbed or emitted frequency, in particular resonant frequency, or an absorbed or emitted frequency spectrum of an electromagnetic radiation, which is proportional to the extent of the lateral undercut.

3.  Device according to Claim 1 or 2, **characterized in that** the passive electronic component (31) is embodied in the form of a coil (30).

4.  Device according to any of Claims 1 to 3, **characterized in that** the physical measurement variable can be determined from the second signal or from the difference between the first and the second signal.

5.  Device according to any of Claims 1 to 4, **characterized in that** transmitter (43) and receiver (44) are integrated in a component, in particular a processing unit (40) and/or **in that** the transmitter (43) is simultaneously receiver (44) as well.

6.  Device according to any of Claims 1 to 5, **characterized in that** the first signal is a voltage present at the passive electronic component (31), an intensity of an electromagnetic radiation, a radio-frequency power that is emitted continuously or in pulsed fashion, is radiated into the passive electronic component (31) and has a predetermined frequency or predetermined frequency spectrum, or a sequence of chirped radio-frequency pulses or broadband noise pulses of electromagnetic radiation, and **in that** the second signal is an electrical voltage, an absorbed or emitted intensity of an electromagnetic radiation, or a frequency, in particular a resonant frequency, or a frequency spectrum of electromagnetic radiation.

7.  Device according to Claim 3, **characterized in that** the passive electronic component (31) is a coil (30) delineated by structuring in the surface layer (23) and having a first coil end (13) and a second coil end (12), wherein the coil (30) with a base layer (20) forms a capacitor having the sacrificial layer (23) as a dielectric, the capacitance C of which is proportional to the extent to be determined of the lateral undercut of the surface layer (23).

8.  Device according to Claim 7, **characterized in that** the coil (30) together with its capacitance C forms a resonant circuit having a resonant frequency $f_0$, the change $\Delta f_0$ in which is proportional to the extent to be determined of the lateral undercut of the surface layer (23).

9.  Device according to Claim 7, **characterized in that** a plated-through hole (22) is provided, which connects one of the coil ends (12, 13) to the base layer (20).

10. Device according to Claim 7, **characterized in that** the extent of at least one of the coil ends (12, 13) is dimensioned in such a way that a complete undercut of the coil end (12, 13) does not occur.

11. Device according to Claim 1, **characterized in that** the structured surface layer (23) is separated from a base layer (20) by means of the sacrificial layer (21) at least in the region of the passive electronic component (21).

12. Device according to Claim 11, **characterized in that** the base layer (20) is at least substantially composed of silicon or polysilicon or is a silicon wafer.

13. Device according to Claim 1, **characterized in that** the surface layer. (23), at least in the region of the passive electronic component (31), is electrically at least weakly conductive and is composed in particular of silicon or polysilicon or superficially metalized or doped silicon or polysilicon.

14. Device according to Claim 1, **characterized in that** the sacrificial layer (21), at least in the region of the passive electronic component (31), is electrically insulating and is composed in particular of a silicon oxide layer.

15. Device according to Claim 1, **characterized in that** the surface layer (23) is provided with trenches (15, 15') that extend in the depth as far as the sacrificial layer (21).

16. Device according to Claim 15, **characterized in that** the trenches (15) delimit a structure (11) to be undercut in the surface layer (23).

17. Method for determining the extent of the lateral undercut of a structured surface layer (23) on a sacrificial layer (21), wherein, in a first etching method, the surface layer (21) is provided at least regionally with a structuring with trenches (15') and, in a second etching method, proceeding from the trenches (15'), a lateral undercut of the structured surface layer (23) is performed at least regionally, **characterized in that**, in the first etching method, at least one passive electronic component (31) is additionally delineated by structuring from the surface layer (23) regionally, which at least one passive electronic component is likewise undercut during the undercutting of the surface layer (23) and is used to determine a physical measurement variable proportional to the extent of the undercut during the undercutting process.

18. Method according to Claim 17, **characterized in that** the structuring of the surface layer (23) is effected by means of a masking.

19. Method according to Claim 17, **characterized in that** the sacrificial layer (21) is applied on a base layer (20).

20. Method according to Claim 17, **characterized in that** the delineation of the component (31) by structuring is effected by means of the etching of trenches (15).

21. Method according to Claim 17, **characterized in that** a coil (30) as passive electronic component (31) is delineated by structuring from the surface layer (23).

22. Method according to Claim 21, **characterized in that** during a process of undercutting the coil (30), the resonant frequency of a resonant circuit formed with the coil (30) is measured and the extent of the lateral undercut is determined therefrom.

**Revendications**

1. Dispositif de détermination de l'extension d'une sous-gravure latérale d'au moins certaines parties d'une couche structurée de surface (23) située sur une couche sacrifiée (21), qui comprend une couche structurée de surface (23) située sur une couche sacrifiée (21), certaines parties de la couche structurée de surface (23) présentant au moins un composant électronique passif (31) qui permet de déterminer une grandeur physique de mesure proportionnelle à l'extension de la sous-gravure latérale,
**caractérisé en ce que**
il présente au moins un émetteur (43) qui émet un premier signal et au moins un récepteur (44) qui détecte un deuxième signal, le composant électronique passif (31) interagissant avec le premier signal pour ainsi former le deuxième signal ou pour convertir le premier signal en le deuxième signal.

2. Dispositif selon la revendication 1, **caractérisé en ce que** le composant électronique passif (31) permet de déterminer une capacité, l'intensité absorbée ou émise d'un rayonnement électromagnétique, une fréquence absorbée ou émise, en particulier une fréquence de résonance, ou un spectre de fréquences absorbées ou émises d'un rayonnement électromagnétique, proportionnellement à l'extension de la sous-gravure latérale.

3. Dispositif selon les revendications 1 ou 2, **caractérisé en ce que** le composant électronique passif (31) est configuré sous la forme d'une bobine (30).

4. Dispositif selon l'une des revendications 1 à 3, **caractérisé en ce que** la grandeur physique de mesure peut être déterminée à partir du deuxième signal ou à partir de la différence entre le premier et le deuxième signal.

5. Dispositif selon l'une des revendications 1 à 4, **caractérisé en ce que** l'émetteur (43) et le récepteur (44) sont intégrés dans un composant, en particulier une unité de traitement (40), et/ou **en ce que** l'émetteur (43) constitue également le récepteur (44).

6. Dispositif selon l'une des revendications 1 à 5, **caractérisé en ce que** le premier signal est une tension appliquée sur le composant électronique passif (31), l'intensité d'un rayonnement électromagnétique, une puissance à haute fréquence de fréquence prédéterminée ou à spectre de fréquences prédéterminées émises en continu ou par impulsions et injectées dans le composant électronique passif (31), ou une succession d'impulsions stridulées à haute fréquence ou d'impulsions de bruit à large bande d'un rayonnement électromagnétique, et **en ce que** le deuxième signal est une tension électrique, l'intensité absorbée ou émise d'un rayonnement électromagnétique, une fréquence, en particulier une fréquence de résonance, ou le spectre de fréquences d'un rayonnement électromagnétique.

7. Dispositif selon la revendication 3, **caractérisé en ce que** le composant électronique passif (31) est une bobine (30) formée par structuration de la couche de surface (23) et présentant une première extrémité de bobine (13) et une deuxième extrémité de bobine (12), la bobine (30) formant avec la couche de base (20) un condensateur dont la couche sacrifiée (23) forme le diélectrique et dont la capacité C est proportionnelle à l'extension qui doit être déterminée de la sous-gravure latérale de la couche de surface (23).

8. Dispositif selon la revendication 7, **caractérisé en ce que** par sa capacité C, la bobine (30) forme en même temps un circuit oscillant dont la fréquence de résonance est $f_0$, dont la variation $\Delta f_0$ est proportionnelle à l'extension qui doit être déterminée de la sous-gravure latérale de la couche de surface (23).

9. Dispositif selon la revendication 7, **caractérisé en ce qu'**il présente un passage de contact (22) qui relie l'une des extrémités (12, 13) de la bobine à la couche de base (20).

10. Dispositif selon la revendication 7, **caractérisé en ce que** l'extension d'au moins l'une des extrémités (12, 13) de la bobine est dimensionnée de manière à empêcher une sous-gravure complète de l'extrémité (12, 13) de la bobine.

11. Dispositif selon la revendication 1, **caractérisé en ce que** la partie occupée par le composant électronique passif (31) dans la couche structurée de surface (23) est séparée de la couche de base (20) par la couche sacrifiée (21).

12. Dispositif selon la revendication 11, **caractérisé en ce que** la couche de base (20) est au moins largement constituée de silicium ou de polysilicium ou est une galette de silicium.

13. Dispositif selon la revendication 1, **caractérisé en ce qu'**au moins la partie de la couche de surface (23) occupée par le composant électronique passif (31) est au moins faiblement conductrice et est constituée en particulier de silicium, de polysilicium ou de silicium ou polysilicium métallisés ou dopés en surface.

14. Dispositif selon la revendication 1, **caractérisé en ce qu'**au moins la partie de la couche sacrifiée (21) occupée par le composant électronique passif (31) est électriquement isolante et est en particulier constituée d'une couche d'oxyde de silicium.

15. Dispositif selon la revendication 1, **caractérisé en ce que** la couche de surface (23) est dotée de tranchées (15, 15') dont la profondeur atteint la couche sacrifiée (21).

16. Dispositif selon la revendication 15, **caractérisé en ce que** les tranchées (15) délimitent dans la couche de surface (23) une structure (11) qui doit être sous-gravée.

17. Procédé de détermination de l'extension de la sous-gravure latérale d'une couche structurée de surface (23) située sur une couche sacrifiée (21), au moins certaines parties de la couche de surface (23) étant dotées dans une première opération de gravure d'une structuration qui présente des tranchées (15'), une sous-gravure latérale étant réalisée dans au moins certaines parties de la couche structurée de surface (23) dans une deuxième opération de gravure partant des tranchées (15'),
**caractérisé en ce que**
au moins un composant électronique passif (31) est de plus formé dans certaines parties de la couche de surface (23) au cours de la première opération de gravure, ce composant étant également sous-gravé lors de la sous-gravure de la couche de surface (23),
et **en ce qu'**une grandeur physique de mesure proportionnelle à l'extension de la sous-gravure est déterminée lors de la sous-gravure.

**18.** Procédé selon la revendication 17, **caractérisé en ce que** la structuration de la couche de surface (23) s'effectue à travers un masque.

**19.** Procédé selon la revendication 17, **caractérisé en ce que** la couche sacrifiée (21) est appliquée sur une couche de base (20).

**20.** Procédé selon la revendication 17, **caractérisé en ce que** la formation du composant (31) par structuration s'effectue par gravure de tranchées (15).

**21.** Procédé selon la revendication 17, **caractérisé en ce que** le composant électronique passif (31) est une bobine (30) formée par structuration de la couche de surface (23).

**22.** Procédé selon la revendication 21, **caractérisé en ce que** lors de la sous-gravure de la bobine (30), la fréquence de résonance d'un circuit oscillant formé avec la bobine (30) est mesurée, l'extension de la sous-gravure latérale étant déterminée à partir de cette fréquence de résonance.

EP 1 080 492 B1

Fig. 1

Fig. 2

Fig. 3

**EP 1 080 492 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19847455